# EUROPEAN PATENT APPLICATION

(11) **EP 1 798 305 A1**
(43) Date of publication of application: **20.06.2007**
(21) Application number: 06256250.9
(22) Date of filing: 08.12.2006
(51) Int. Cl.: C23C 14/06, F16C 33/16

(54) **Hard carbon film, production method thereof, and sliding member**

(30) Priority: 15.12.2005 JP 2005361994
(71) Applicant: TOYOTA JIDOSHA KABUSHIKI KAISHA, Toyota-shi, Aichi-ken, 471-8571 (JP)
(72) Inventor: Nakagawa, Ikuo, Toyota-shi Aichi-ken 471-8571 (JP); Fuwa, Yoshio, Toyota-shi Aichi-ken 471-8571 (JP); Ogawa, Masaaki, Toyota-shi Aichi-ken 471-8571 (JP); Ozaki, Yoshinori, Toyota-shi Aichi-ken 471-8571 (JP)
(74) Representative: Smith, Samuel Leonard

(57) **Abstract**

A hard carbon film (3) formed on a substrate (1) via an intermediate layer (2) is made up of a diamond-like carbon layer (6) and a graphite particle deposition layer (7) formed on the diamond-like carbon layer (6). The I_{D}/I_{G} of the graphite particle deposition layer (7) that is a ratio of the integrated intensity I_{D} of a peak representing the D band and the integrated intensity I_{G} of a peak representing the G band that are obtained through the peak separation of the Raman spectrum based on the Raman spectroscopic analysis is 1 or less.

## Description

### BACKGROUND OF THE INVENTION

### 1. Field of the Invention

The invention relates to a hard carbon film and a production method thereof as well as a sliding member. More particularly, the invention relates to a hard carbon film that includes a diamond-like carbon layer and a production method thereof as well as a sliding member made up by forming the hard carbon film on a substrate surface. The hard carbon film and the sliding member in accordance with the invention can be suitably used, for example, in vehicular engine component parts such as valve lifters, piston rings, piston skirts, etc.

### 2. Description of the Related Art

The diamond-like carbon, having high hardness and low friction coefficient, has come to be used as surface reforming films of various sliding members, mechanical component parts, tools, magnetic disks, etc.

In order to cope with the recent fuel economy regulations regarding motor vehicles, it is very important to develop a technology for reducing sliding resistance. Therefore, it has become a major task to reduce the sliding resistance in motor vehicle component parts and, particularly, engine component parts.

Japanese Patent Application Publication No. JP-A-2004-339564 discloses a sliding member as follows. In this sliding member, an intermediate layer having a metal layer made of chrome, titanium or the like as a lower layer, and a mixture layer of metal and carbon as an upper layer is layered on a surface of the substrate. Besides, in the sliding member, a diamond-like carbon layer is formed on the intermediate layer, and a solid lubricant coating film made of molybdenum disulfide or the like is formed on the diamond-like carbon layer.

However, the aforementioned sliding member has a problem that, in an initial period of use, a long time is needed before the friction coefficient declines and stabilizes at a low friction coefficient, that is, the fitting property is insufficient. Causes of this are considered be that the solid lubricant coating film, forming the outermost surface, is less apt to be smoothed by sliding, and that the crystal structure of the solid lubricant coating film is less apt to change into a structure excellent in lubricity.

### SUMMARY OF THE INVENTION

It is an object of the invention to provide a hard carbon film of high fitting property whose friction coefficient can be quickly declined by sliding in an initial period of use so as to stabilize at a low friction coefficient value in an early period, and a production method thereof as well as a sliding member.

A first aspect of the invention relates to a hard carbon film that includes a diamond-like carbon layer (hereinafter, referred to as "DLC layer") formed on a substrate directly or via an intermediate layer. The hard carbon film includes a graphite particle deposition layer (hereinafter, referred to as "Gr particle deposition layer") formed on the DLC layer. An I_{D}/I_{G} of the Gr particle deposition layer that is a ratio of the integrated intensity I_{D} of a peak representing a D band and the integrated intensity I_{G} of a peak representing a G band that are obtained through the peak separation of the Raman spectrum based on the Raman spectroscopic analysis is 1 or less.

According to the first aspect of the invention, both the DLC layer and the Gr particle deposition layer improve the antiwear property, and decline the friction coefficient. The formation method of the DLC layer is not particularly limited. This formation method may employ, for example, an ionization vapor deposition technique, a plasma CVD technique, an ark ion plating technique, a sputtering technique, etc. Besides, the formation method of the Gr particle deposition layer may employ a sputtering technique. However, from the viewpoint of seeking simplification of the production process, the sputtering technique may be used to consecutively form the intermediate layer, the DLC layer and the Gr particle deposition layer.

The thicknesses of the intermediate layer, the DLC layer and the Gr particle deposition layer are appropriately settable in accordance with the usage of a component part to which the invention is applied. For example, the thickness of the intermediate layer is about 0.1 to 1.0 µm, and the thickness of the DLC layer is about 0.5 to 10 µm, and the thickness of the Gr particle deposition layer is about 0.5 to 5 µm.

Besides, as for the DLC layer and the Gr particle deposition layer, one or more species of metals, such as Cr, Ti, Si, W, B, etc., may be added thereto.

In the evaluation of the Gr particle deposition layer based on the Raman spectrum, a spectrum that has a broad peak near 1500 cm⁻¹ and has a slight shoulder near 1400 cm⁻¹ is obtained. The peak separation through the curve fitting of this Raman spectrum using the Gaussian function and the Lorenz function provides a peak representing the G band near 1550 cm⁻¹, and a peak representing the D band near 1350 cm⁻¹. In the hard carbon film in accordance with the first aspect of the invention, the Gr particle deposition layer is specified. The I_{D}/I_{G}, that is, the ratio between the integrated intensity I_{D} of the peak representing the D band and the integrated intensity I_{G} of the peak representing the G band, is 1 or less.

The measurement of the Raman spectrum by the Raman spectroscopic analysis employs, for example, a microscopic laser Raman spectroscopic device (trade name "NRS-1000" by Nippon Bunko). In this case, measurement is performed in the following measurement condition: a laser wavelength of 532.20 nm, and a laser diameter of 1 µm.

The peak representing the G band results from a Gr structure in which carbon atoms are sp²-bonded. The peak representing the D band results from the sp³ bond and an amorphous structure.

Therefore, in the Gr particle deposition layer, lower I_{D}/I_{G} values mean correspondingly lower proportions of the amorphous structure to the Gr structure. In other words, the lower the I_{D}/I_{G} of a Gr particle deposition layer, the closer to graphite it is. Therefore, in the hard carbon coating film, a Gr particle deposition layer whose I_{D}/I_{G} is 1 or less has a structure that is very close to that of graphite, and greatly contributes to improvement in the fitting property.

Therefore, the hard carbon film as mentioned above is a film with high fitting property whose friction coefficient quickly declines due to sliding in an initial period of use, and stabilizes at a low friction coefficient level in an early period.

From the viewpoint of further improving the fitting property of the hard carbon coating film in accordance with the first aspect of the invention, the I_{D}/I_{G} may be 0.5 or less, and it is particularly good if it is 0.1 or less.

The Gr particle deposition layer is a layer formed by depositing Gr particles.

In the hard carbon film, the hardness of the DLC layer may be 10 GPa (Hv1000 in the Vickers hardness) or higher.

If the hardness of the DLC layer is less than 10 GPa, it becomes difficult to effectively improve the antiwear property of the entire hard carbon film. Besides, it becomes difficult to secure a strength of the entire hard carbon film. The hardness of the DLC layer may be 12 GPa or higher, and it is particularly good if it is 15 GPa. From the viewpoint of improving the antiwear property, the higher the hardness of the DLC layer in the hard carbon film is, the better it is. However, for a reason from the upper limit in the material property intrinsic to DLC, the hardness of the DLC layer has an upper limit of about 80 GPa.

Incidentally, for example, if the DLC layer is formed by a sputtering technique, the hardness of the DLC layer is appropriately settable by adjusting the bias voltage, the introduction amount of hydrocarbon, etc.

A second aspect of the invention relates to a production method of a hard carbon film in which a hard carbon film is formed on a substrate directly or via an intermediate layer. This production method comprises the step of forming a DLC layer on the substrate or the intermediate layer by sputtering a solid carbon target by exposure to a rare gas plasma while introducing a hydrocarbon gas (hereinafter, referred to as "DLC layer forming process"), and the step of forming a Gr particle deposition layer on the DLC layer by sputtering a solid carbon target by exposure to a rare gas plasma while introducing an amount of a hydrocarbon gas which makes a volume ratio of the hydrocarbon gas to a total amount of a rare gas and the hydrocarbon gas equal to or less than 0.5% (hereinafter, referred to as "Gr particle deposition layer forming process").

According to the second aspect of the invention, the production method comprises the DLC layer forming process and the Gr particle deposition layer forming process, and consecutively forms the DLC layer and the Gr particle deposition layer by the sputtering technique of exposing the solid carbon target to a rare gas plasma. In addition, if the intermediate layer is formed, the intermediate layer may also be formed by the sputtering technique.

The kind of rare gas for generating the rare gas plasma is not particularly limited. As for the kind of rare gas, a generally used gas, such as Ar (argon) or the like, may be adopted. Besides, the kind of hydrocarbon gas used in the DLC layer forming process and the Gr particle deposition layer forming process is not particularly limited either. As for the kind of hydrocarbon gas, an appropriate one may be selected from methane, acetylene, ethylene, benzene, etc.

In the DLC layer forming process, the DLC layer is formed on the substrate or the intermediate layer by the sputtering technique of exposing the solid carbon target to a rare gas plasma while introducing a hydrocarbon gas.

In the foregoing production method of the hard carbon film, the Gr particle deposition layer of which an I_{D}/I_{G} that is a ratio between an integrated intensity I_{D} of a peak representing a D band and an integrated intensity I_{G} of a peak representing a G band that are obtained through peak separation of a Raman spectrum based on a Raman spectroscopic analysis is 1 or less may be formed in the Gr particle deposition layer forming process.

In the foregoing production method of the hard carbon film, the Gr particle deposition layer may be formed without introducing the hydrocarbon gas in the Gr particle deposition layer forming process.

According to the production method of the hard carbon film, the Gr particle deposition layer can be formed by the sputtering technique. However, if sputtering is performed while a hydrocarbon gas is being supplied, the Gr particle deposition layer will contain gas-decomposition carbon and gas-decomposition hydrogen that are decomposition components of the hydrocarbon gas are. If the Gr particle deposition layer contains the gas-decomposition carbon as carbonaceous element or the gas-decomposition hydrogen, the deposition of Gr particles is inhibited so that a good Gr particle deposition layer cannot be formed. Therefore, the self-lubricity and the like inherent in graphite are inhibited. Therefore, the less the content of the gas-decomposition carbon and the gas-decomposition hydrogen in the Gr particle deposition layer is, the better it is. It is particularly good if the content is 0 at%, that is, if the Gr particle deposition layer contains no gas-decomposition carbon and no gas-decomposition hydrogen.

In the production method of the hard carbon film, the DLC layer whose hardness is 10 GPa or higher may be formed in the DLC layer forming process.

In the DLC layer forming process, it is advisable to appropriately set the bias voltage applied to the substrate, the introduction amount of hydrocarbon gas, etc. so that the hardness of the DLC layer formed becomes 10 GPa or higher. From such a viewpoint, it is advisable that the bias voltage applied to the substrate be about 30 to 450V, and it is particularly good if it is set at about 50 to 200V. Besides, it is advisable that the volume ratio of the hydrocarbon gas to the total amount of the rare gas and the hydrocarbon gas be about 0.5 to 20%, and it is particularly good if it is about 2 to 10%.

In the Gr particle deposition layer forming process, the amount of the hydrocarbon gas which makes the volume ratio of the hydrocarbon gas to the total amount of the rare gas and the hydrocarbon gas equal to or less than 0.5% is introduced. By performing the sputtering technique of exposing the solid carbon target to a rare gas plasma while introducing the hydrocarbon gas, the Gr particle deposition layer is formed on the DLC layer.

If the volume ratio of the hydrocarbon gas in the Gr particle deposition layer forming process exceeds 0.5%, the content of the gas-decomposition carbon and the gas-decomposition hydrogen in the Gr particle deposition layer formed becomes excessively large. Therefore, the fitting property or the antiwear property cannot not be favorably improved. Then, the less the volume ratio of the hydrocarbon gas in the Gr particle deposition layer forming process is, the better it is. This means that it is most favorable that the volume ratio be 0%, that is, the hydrocarbon gas be not introduced in the Gr particle deposition layer forming process. It is particularly good if the Gr particle deposition layer is formed in this manner.

If the volume ratio of the hydrocarbon gas in the Gr particle deposition layer forming process is 0.5% or less, the Gr particle deposition layer of which the I_{D}/I_{G} that is the ratio of the integrated intensity I_{D} of the peak representing the D band and the integrated intensity I_{G} of the peak representing the G band that are obtained through peak separation of the Raman spectrum based on the Raman spectroscopic analysis is 1 or less can be formed.

A third aspect of the invention is a sliding member comprising a substrate and the foregoing hard carbon film.

Therefore, according to the sliding member in accordance with the third aspect of the invention, the fitting property and the antiwear property can be favorably improved. Hence, this sliding member can be suitably used, for example, in valve lifters, piston rings, and piston skirts as vehicular engine component parts.

The material of the substrate is not particularly limited, and may be a ferrous material, a nonferrous material, or a ceramic. For example, steel materials, such as carbon steel or various alloy steels for ferrous plates or mechanical structures, hardened steel, etc., cast iron materials, such as flake graphite cast iron, spheroidal graphite cast iron, etc., or Al alloys, Mg alloys, etc., may be suitably used.

The intermediate layer is a layer for improving the adhesiveness between the substrate and the hard carbon film, and may be formed on the substrate in accordance with need. The kind of the intermediate layer is not particularly limited but may be appropriately selected in accordance with the material of the substrate, as long as the intermediate layer is able to improve the adhesiveness between the substrate and the hard carbon film. For example, the kind of the intermediate layer may be a combination of one or more species of metal elements such as Cr, Ti, Si, W, B, etc.

Besides, from the viewpoint of further improving the adhesiveness between the substrate and the hard carbon film, the intermediate layer may be constructed of a metal layer made of the aforementioned metal element or elements, and a gradient mixture layer made of the aforementioned metal element or elements and carbon in which the ratio therebetween is changed in a gradient fashion (such that the proportion of metal increases with approach to the metal layer).

The formation method for the intermediate layer is not particularly limited, and may employ an ionization vapor deposition technique, a plasma CVD technique, an ark ion plating technique, a sputtering technique, etc.

### BRIEF DESCRIPTION OF THE DRAWINGS

The foregoing and further objects, features and advantages of the invention will become apparent from the following description of preferred embodiments with reference to the accompanying drawings, wherein like numerals are used to represent like elements and wherein:
FIG 1 is a sectional view schematically showing a sliding member in accordance with an example of the invention;
FIG 2 is a diagram showing results of investigation of the friction coefficients and the fitting properties of sliding members in accordance with Examples 1, 4 and Comparative Examples 2 to 4 through a friction wear test;
FIG 3 is a diagram showing results of investigation of the antiwear property of sliding members in accordance with Examples 1 to 3 and Comparative Example 1 through a friction wear test; and
FIG 4 is a diagram showing results of investigation of the antiwear property of sliding members in accordance with Example 1 and Comparative Example 2 through a friction wear test.

### DETAILED DESCRIPTION OF THE PREFERRED EMBODIMENTS

Hereinafter, the invention will be further described in detail with reference to embodiments and examples. The invention is not limited to these embodiments or examples.

### (Example 1)

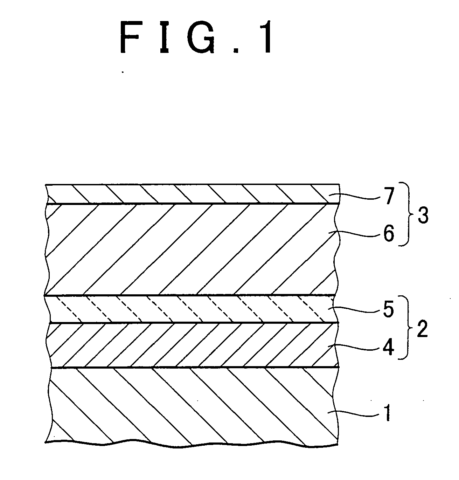

A sliding member in accordance with this example shown in FIG. 1 is constructed of a substrate 1, an intermediate layer 2 formed on the substrate 1, and a hard carbon film 3 formed on the intermediate layer 2.

The substrate 1 is made of SUS440C whose surface roughness is 0.02 µmRa.

The intermediate layer 2 is constructed of a Cr (chrome) metal layer 4 of 0.5 µm in thickness formed on the substrate 1, a Cr/C gradient mixture layer 5 of 0.3 µm in thickness formed on the Cr metal layer 4. As for the Cr/C gradient mixture layer 5, the ratio between Cr and D changes in a gradient fashion such that the proportion of C (carbon) gradually increases with approach from the Cr metal layer 4 to a DLC layer (described below) of the hard carbon film 3. Incidentally, although in the example of the invention, the intermediate layer 2 is formed on the substrate 1, it is not altogether necessary to form the intermediate layer 2.

The hard carbon film 3 is constructed of a DLC layer 6 of 1.0 µm in thickness formed on the Cr/C gradient mixture layer 5 of the intermediate layer 2, and a Gr particle deposition layer 7 of 0.2 µm in thickness formed on the DLC layer 6.

The hardness of the DLC layer 6 in the hard carbon film 3 was measured and found to be 18 GPa (Hv1800).

Besides, with regard to the Gr particle deposition layer 7 in the hard carbon film 3, the Raman spectrum was measured in the above-stated measurement condition through the use of a Raman spectroscopic device. The peak separation through the curve fitting of the obtained Raman spectrum using the Gaussian function and the Lorenz function provides a peak that represents the G band near 1550 cm⁻¹, and a peak that represents the D band near 1350 cm⁻¹. Then, the I_{D}/I_{G} that is the ratio between the integrated intensity I_{D} of the peak representing the D band and the integrated intensity I_{G} of the peak representing the G band was 0.51 as shown in Table 1, which will be shown later.

The sliding member in accordance with the example having the aforementioned construction was produced as described below through an unbalance magnetron sputtering technique (hereinafter, referred to as "UBMS technique") using a sputtering device ("UBMS202" by Kobe Seikosho) (not shown).

### <Oxide Layer Removing Process>

First, a substrate 1, and a sheet of a graphite target and a sheet of a Cr target as solid carbon targets were placed at their respective predetermined positions in a sputtering device. Then, the sputtering device was evacuated to 3.0×10⁻³ Pa. After the temperature of the substrate 1 was raised to 200°C, the substrate 1 surface was exposed to Ar plasma (Ar bombardment) to remove the oxide layer of the substrate 1 surface.

<Intermediate Layer Forming Process>After that, while the Ar gas for plasma generation and a methane gas were flowed in the device at an introduction amount of 190 ml/min and an introduction amount of 10 ml/min, respectively, the Cr target was sputtered, whereby a Cr metal layer 4 was formed on the substrate 1. Then, the Cr target and the graphite target were simultaneously sputtered so that the amounts of sputter thereof were changed in a gradient fashion, whereby a Cr/C gradient mixture layer 5 was formed on the Cr metal layer 4.

In this manner, an intermediate layer 2 made up of the Cr metal layer 4 and the Cr/C gradient mixture layer 5 was formed on the substrate 1.

Incidentally, in this intermediate layer forming process, the bias voltage applied to the substrate 1 was set at 100V.

Besides, the volume ratio of the methane gas to the total amount of the Ar gas and the methane gas in this intermediate layer forming process and in a DLC layer forming process described below is 5%.

### <DLC Layer Forming Process>

Furthermore, consecutively from the intermediate layer forming process, the graphite target was sputtered, whereby a DLC layer 6 was formed on the intermediate layer 2.

### <Gr Particle Deposition Layer Forming Process>

After the DLC layer 6 was formed, the introduction of the methane gas into the device was stopped. While only the Ar gas was being flowed at an introduction amount of 200 ml/min, the graphite target was sputtered, whereby the Gr particle deposition layer 7 was formed on the DLC layer 6.

In this manner, a hard carbon film 3 made up of the DLC layer 6 and the Gr particle deposition layer 7 was formed on the intermediate layer 2.

Incidentally, in the DLC layer forming process and the Gr particle deposition layer forming process, the bias voltage applied to the substrate 1 was set at 100V.

Besides, the volume ratio of the Ar gas to the total amount of the Ar gas and the methane gas in the Gr particle deposition layer forming process in this example is 0% as shown in Table 1, which will be shown below.

### (Example 2)

With regard to a sliding member in accordance with Example 2 of the invention, the bias voltage applied to the substrate 1 in the DLC layer forming process is altered to 80V. Except for this process, the sliding member is obtained by substantially the same method as in Example 1.

The hardness of the DLC layer 6 in this sliding member is 15 GPa (Hv1500).

### (Example 3)

With regard to a sliding member in accordance with Example 3 of the invention, the bias voltage applied to the substrate 1 in the DLC layer forming process is altered to 65V Except for this process, the sliding member is obtained by substantially the same method as in Example 1.

The hardness of the DLC layer 6 in this sliding member is 12 GPa (Hv1200).

### (Example 4)

With regard to a sliding member in accordance with Example 4 of the invention, in the Gr particle deposition layer forming process, while Ar and the methane gas are flowed in the device at an introduction amount of 199 ml/min and an introduction amount of 1 ml/min, respectively, the graphite target is sputtered, whereby a Gr particle deposition layer 7 is formed. Except for this process, the sliding member is obtained by substantially the same method as in Example 1.

Incidentally, the volume ratio of the Ar gas to the total amount of the Ar gas and the methane gas in the Gr particle deposition layer forming process of this example is 0.5%.

Besides, as for the Gr particle deposition layer 7 of the hard carbon film 3 in accordance with Example 4, the I_{D}/I_{G} is 0.99.

### (Comparative Example 1)

With regard to a sliding member in accordance with Comparative Example 1, the bias voltage applied to the substrate 1 in the DLC layer forming process is altered to 50V. Except for this process, the sliding member is obtained by substantially the same method as in Example 1.

Incidentally, the hardness of the DLC layer 6 in this sliding member is 9 GPa (Hv900).

### (Comparative Example 2)

With regard to the sliding member in accordance with Comparative Example 2, the Gr particle deposition layer forming process is not carried out. Except for this process, the sliding member is obtained by substantially the same method as in Example 1.

This sliding member is constructed of a substrate 1, an intermediate layer 2 formed on the substrate 1 and made up of a Cr metal layer 4 and a Cr/C gradient mixture layer 5, and a hard carbon film formed on the intermediate layer 2 and made up only of a DLC layer 6.

### (Comparative Example 3)

With regard to a sliding member in accordance with Comparative Example 3, in the Gr particle deposition layer forming process, while Ar and a methane gas are being flowed in the device at an introduction amount of 195 ml/min and an introduction amount of 5 ml/min, respectively, the graphite target was sputtered, whereby a Gr particle deposition layer 7 is formed. Except for this process, the sliding member is obtained by substantially the same method as in Example 1.

Incidentally, the volume ratio of the Ar gas to the total amount of the Ar gas and the methane gas in the Gr particle deposition layer forming process of this comparative example is 2.5%.

Besides, as for the Gr particle deposition layer 7 of the hard carbon film in accordance with Comparative Example 3, the I_{D}/I_{G} is 2.11.

### (Comparative Example 4)

With regard to a sliding member in accordance with Comparative Example 4, in the Gr particle deposition layer forming process, while Ar and a methane gas are being flowed in the device at an introduction amount of 197.5 ml/min and an introduction amount of 2.5 ml/min, respectively, the graphite target is sputtered, whereby a Gr particle deposition layer 7 is formed. Except for this process, the sliding member is obtained by substantially the same method as in Example 1.

Incidentally, the volume ratio of the Ar to the total amount of the Ar gas and the methane gas in the Gr particle deposition layer forming process of this example is 1.25%.

Besides, as for the Gr particle deposition layer 7 of the hard carbon film in accordance with Comparative Example 4, the I_{D}/I_{G} is 1.17.

**[Table. 1]**

| | Volume ratio of Ar (%) | I_{D}/I_{G} |
|---|---|---|
| Example 1 | 0 | 0.51 |
| Example 4 | 0.5 | 0.99 |
| Comparative Example 3 | 2.5 | 2.11 |
| Comparative Example 4 | 1.25 | 1.17 |

### (Friction Coefficient and Fitting Property Evaluation-Influence of Gr Particle Deposition Layer)

With respect to the sliding members of Examples 1, 4 and Comparative Examples 2 to 4, a block-on-ring friction wear test (LFW-1 test) is performed to evaluate the friction coefficient and the fitting property thereof.

This friction wear test is performed in a condition where a standard ring (SAE4620) for the LFW-1 test is used as an opponent ring, and where while this opponent ring is half dipped in an oil bath (lubricating oil: a base oil of engine oil 5W-30; bath temperature: 80°C), the opponent ring is rotated at a rotation speed of 160 rpm (0.3 m/s), and where the hard carbon film of each sliding member is pressed against the rotating ring with a load P of 30kg (320 MPa) for 30 minutes.

In addition, for comparison, substantially the same test is performed with respect to a substrate 1 made of SUS440C.

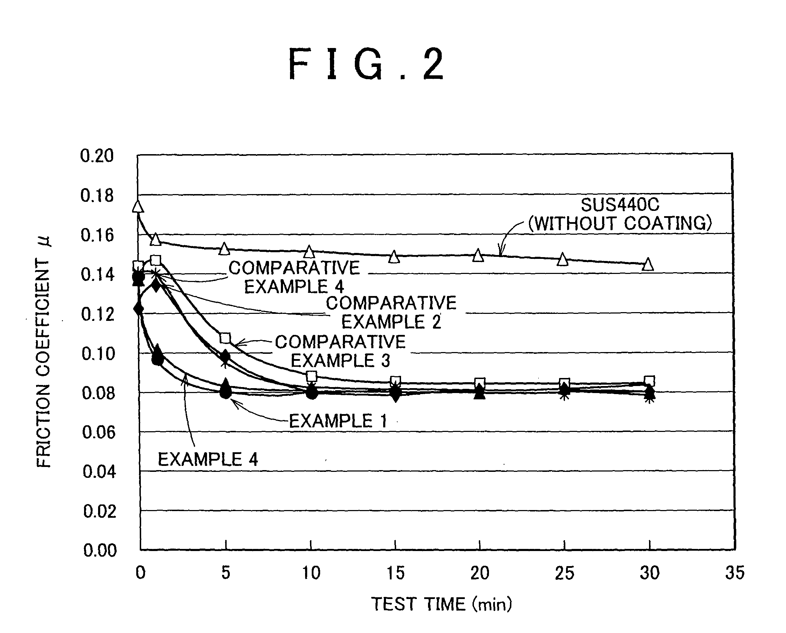

As shown by results of the test in FIG 2, the sliding members of Examples 1 and 4, each having a Gr particle deposition layer 7 whose I_{D}/I_{G} is 1 or less, are excellent in the fitting property, and exhibit early decline of the friction coefficient. A reason for this is considered to be that the Gr particle deposition layer 7 whose I_{D}/I_{G} is 1 or less is apt to become smoothed by sliding, and is apt to change into a crystal structure that is excellent in lubricity.

On the other hand, the sliding members of Comparative Examples 3 and 4, each having a Gr particle deposition layer 7 whose I_{D}/I_{G} exceeds 1, are poor in fitting property, and bring about results substantially the same as the results of the sliding member of Comparative Example 2 that does not have a Gr particle deposition layer 7. A reason for this is considered to be that the mixing-in of the gas-decomposition carbon and the gas-decomposition hydrogen inhibited the deposition of graphite, and the smoothing by sliding and the change into a crystal structure excellent in lubricity became less likely to occur.

Therefore, it can be understood that by reducing the I_{D}/I_{G} of the Gr particle deposition layer 7 to or less 1, the fitting property of the hard carbon film 3 can be effectively improved.

### (Antiwear Property Evaluation--Influence of Hardness of DLC Layer)

With respect to the sliding members of Examples 1 to 3 and Comparative Example 1, the aforementioned block-on-ring friction wear test (LFW-1 test) is performed to evaluate the antiwear property thereof.

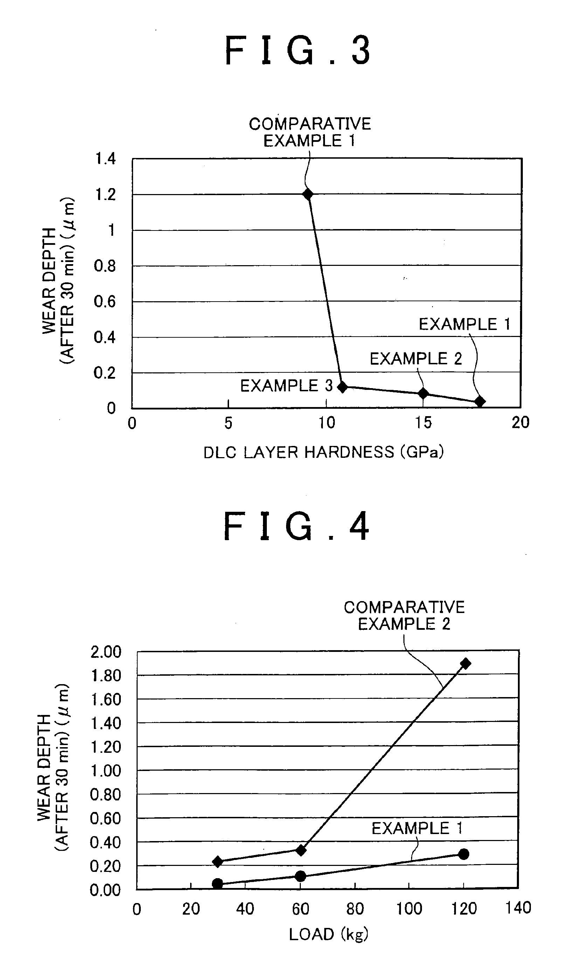

Results of measurement of the wear depths after the end of the test are shown in FIG 3.

As is apparent from FIG 3, as for each of the sliding members of Examples 1 to 3, the hardness of the DLC layer 6 is 10 GPa or greater. In each of the sliding members, the wear depth is only about 0.1 µm or less, and the antiwear property is remarkably improved.

On the other hand, as for the sliding member of Comparative Example 1, the hardness of the DLC layer is 9 GPa. The wear depth of this sliding member is 1.2 µm. A reason for this is considered to be that since the hardness of the DLC layer 6 is low, the insufficient strength of the DLC layer 6 declines the antiwear property of the entire film.

Therefore, it can be understood that by making the hardness of the DLC layer 6 equal to or greater than 10 GPa, the antiwear property of the hard carbon film 3 can be effectively improved.

### (Antiwear Property Evaluation--Influence of Gr Particle Deposition Layer)

With respect to the sliding members of Example 1 and Comparative Example 2, the block-on-ring friction wear test (LFW-1 test) is performed while the load P is variously altered as follows: P=30 kg (320 MPa), 60 kg (420 MPa), 120 kg (600 MPa), whereby the antiwear property thereof is evaluated. Results of the test are shown in FIG 4.

As is apparent from FIG 4, by forming a Gr particle deposition layer 7 whose I_{D}/I_{G} is 1 or less, the antiwear property can be improved and, in particular, the antiwear property under high surface pressure can be remarkably improved. This is also considered to be caused by the crystal structure of the Gr particle deposition layer 7. Specifically, the Gr particle deposition layer 7 whose I_{D}/I_{G} is 1 or less is apt to become smoothed by sliding, and is apt to change into a crystal structure that is excellent in lubricity. Besides this, due to a self-regeneration function, the Gr particle deposition layer 7 regenerates and maintains such a structure. Therefore, it is considered that the impact of sliding can be absorbed and the propagation thereof to the DLC layer 6 can be restrained, and that therefore the antiwear property in the whole hard carbon film 3 will improve.

These results conclude that the hard carbon film 3 made up of the DLC layer 6 whose hardness is 10 GPa or higher and the Gr particle deposition layer 7 whose I_{D}/I_{G} is 1 or less will achieve improved fitting property and improved antiwear property and reduced friction coefficient.

While the invention has been described with reference to preferred embodiments thereof, it is to be understood that the invention is not limited to the preferred embodiments or constructions. To the contrary, the invention is intended to cover various modifications and equivalent arrangements. In addition, while the various elements of the preferred embodiments are shown in various combinations and configurations, which are exemplary, other combinations and configurations, including more, less or only a single element, are also within the spirit and scope of the invention.

## Claims

1. A hard carbon film comprising a diamond-like carbon layer (6) formed on a substrate (1) directly or via an intermediate layer (2), **characterized by** comprising:
a graphite particle deposition layer (7) formed on the diamond-like carbon layer (6), wherein
an I_{D}/I_{G} of the graphite particle deposition layer (7) that is a ratio of an integrated intensity I_{D} of a peak representing a D band and an integrated intensity I_{G} of a peak representing a G band that are obtained through peak separation of a Raman spectrum based on a Raman spectroscopic analysis is 1 or less.

2. The hard carbon film according to claim 1, wherein
a hardness of the diamond-like carbon layer (6) is 10 GPa or greater.

3. A production method of a hard carbon film in which the hard carbon film (3) is formed on a substrate (1) directly or via an intermediate layer (2), **characterized by** comprising the steps of:
forming a diamond-like carbon layer (6) on the substrate (1) or on the intermediate layer (2) by sputtering a solid carbon target by exposure to a rare gas plasma while introducing a hydrocarbon gas; and
forming a graphite particle deposition layer (7) on the diamond-like carbon layer (6) by sputtering the solid carbon target by exposure to a rare gas plasma while introducing an amount of a hydrocarbon gas which makes a volume ratio of the hydrocarbon gas to a total amount of a rare gas and the hydrocarbon gas equal to or less than 0.5%.

4. The production method of the hard carbon film according to claim 3, wherein
an I_{D}/I_{G} of the graphite particle deposition layer (7) that is a ratio of an integrated intensity I_{D} of a peak representing a D band and an integrated intensity I_{G} of a peak representing a G band that are obtained through peak separation of a Raman spectrum based on a Raman spectroscopic analysis is 1 or less.

5. The production method of the hard carbon film according to claim 3 or 4, wherein
the graphite particle deposition layer (7) is formed without introducing the hydrocarbon gas.

6. The production method of the hard carbon film according to any one of claims 3 to 5, wherein
a hardness of the diamond-like carbon layer (6) is 10 GPa or greater.

7. A sliding member **characterized by** comprising:
the substrate (1); and
a hard carbon film according to claim 1 or 2.
